# EUROPÄISCHE PATENTANMELDUNG

(11) **EP 0 884 784 A1**
(43) Veröffentlichungstag der Anmeldung: **16.12.1998**
(21) Anmeldenummer: 98104832.5
(22) Anmeldetag: 17.03.1998
(51) Int. Cl.: H01L 27/06, H01L 27/092, H01L 21/8256, H01L 21/8238

(54) **Integrierte CMOS-Schaltungsanordnung und Verfahren zu deren Herstellung**

(30) Priorität: 13.05.1997 DE 19720008
(71) Anmelder: SIEMENS AKTIENGESELLSCHAFT, 80333 München (DE)
(72) Erfinder: Fischer, Hermann, 80807 München (DE); Hofmann, Franz, Dr., 80995 München (DE)

(57) **Zusammenfassung**

Ein Halbleitersubstrat, in dem ein p-Kanal-MOS-Transistor und ein n-Kanal-MOS-Transistor realisiert sind, weist eine erste Siliziumschicht (5), eine verspannte Si₁₋ₓGeₓ-Schicht (6) und eine zweite Siliziumschicht (7)auf, die vorzugsweise durch selektive Epitaxie aufgewachsen werden. Im leitenden Zustand bildet sich in dem p-Kanal-MOS-Transistor ein vergrabener Kanal in der verspannten Si₁₋ₓGeₓ-Schicht und in dem n-Kanal-MOS-Transistor ein Oberflächenkanal in der zweiten Siliziumschicht (7) aus.

## Beschreibung

Bei Strukturverkleinerungen in der MOS-Technik nach dem Prinzip der ähnlichen Verkleinerung bleiben im Mikrometerbereich die Eigenschaften von MOS-Transistoren und CMOS-Schaltungen im wesentlichen erhalten. Bei MOS-Transistoren mit Kanallangen von zum Beispiel unter ca. 200 nm treten jedoch Kurzkanal- und Puncheffekte auf.

Diese können zwar teilweise durch eine erhöhte Dotierung des Substrats ausgeglichen werden, eine derartige hohe Dotierung des Substrats führt jedoch unter anderem zu einer Verschlechterung der Ladungsträgerbeweglichkeit im Kanal. Die Verschlechterung der Ladungsträgerbeweglichkeit im Kanal macht sich besonders bei p-Kanal-MOS-Transistoren bemerkbar.

In CMOS-Schaltungsanordnungen, insbesondere in Invertern, NAND- und NOR-Gattern, Schieberegistern, Speicher-, Logik- und Analogschaltungen, werden sowohl n-Kanal-MOS-Transistoren als auch p-Kanal-MOS-Transistoren eingesetzt, die neben der betragsmäßigen Gleichheit der Einheitsspannung auch die gleiche Steilheit und den gleichen Sättigungsstrom aufweisen müssen. Es ist vorgeschlagen worden (siehe zum Beispiel K. Hoffmann, VLSI-Entwurf Modelle und Schaltungen, 3. Auflage 1996, Seite 333 bis 339), die gleiche Steilheit und den gleichen Sättigungsstrom in sonst gleich aufgebauten n-Kanal-MOS-Transistoren und p-Kanal-MOS-Transistoren dadurch zu erzielen, daß der Kanal des p-Kanal-MOS-Transistors ein zweifach größeres Weiten- zu Längenverhältnis aufweist als der Kanal des n-Kanal-MOS-Transistors. Dadurch soll die um den Faktor 2 geringere Löcherbeweglichkeit im p-Kanal-MOS-Transistor im Vergleich zur Elektronenbeweglichkeit im n-Kanal-MOS-Transistor ausgeglichen werden. Durch diese Maßnahme erhöhen sich jedoch die Fläche und parasitäre Kapazität im p-Kanal-MOS-Transistor.

In A. Sadek et al, Solid-State Electronics, Vol. 38, Nr. 9, (1995), Seiten 1731 bis 1734 und K. Ismael, Lecture at the international School of materials science and technology, Erice, Italy, 13. bis 24.07.1995, Seiten 19 bis 20, ist vorgeschlagen worden, zur Erhöhung der Löcherbeweglichkeit im Kanal eines p-Kanal-MOS-Transistors im Bereich des Kanals eine Schicht aus verspannten Si₁₋ₓGeₓ vorzusehen. Diese Schicht wird dadurch verspannt, daß sie die Gitterkonstante von monokristallinem Silizium aufweist. Das Gitter in dieser Schicht ist in der xy-Ebene angepaßt. Daher besteht Druckspannung in der x- und y-Richtung im SiGe, während in der z-Richtung, die der Wachstumsrichtung entspricht, Zugspannung vorliegt. Man spricht bei derartig elastisch verspannten Heterostrukturen von pseudomorphen Schichten. Zur Herstellung einer CMOS-Schaltungsanordnung werden dabei die p-Kanal-MOS-Transistoren mit einer eine Si₁₋ₓGeₓ-Schicht enthaltenden Kanal und die n-Kanal-MOS-Transistoren mit einem Kanal aus monokristallinem Silizium gebildet. Zur Herstellung der p-Kanal-MOS-Transistoren und der n-Kanal-MOS-Transistoren sind dabei zwei getrennte Prozeßblöcke erforderlich.

Der Erfindung liegt das Problem zugrunde, eine integrierte CMOS-Schaltungsanordnung anzugeben, die mit reduziertem Platzbedarf und reduziertem Prozeßaufwand herstellbar ist. Ferner soll ein Verfahren zur Herstellung einer solchen Schaltungsanordnung angegeben werden.

Dieses Problem wird erfindungsgemäß gelöst durch eine integrierte CMOS-Schaltungsanordnung gemäß Anspruch 1 sowie durch ein Verfahren zu deren Herstellung gemäß Anspruch 3. Weitere Ausgestaltungen der Erfindung gehen aus den Unteransprüchen hervor.

Die erfindungsgemäße integrierte CMOS-Schaltungsanordnung ist in einem Halbleitersubstrat realisiert, das mindestens eine erste Siliziumschicht, eine verspannte Si₁₋ₓGeₓ-Schicht und eine zweite Siliziumschicht aufweist. In dem Halbleitersubstrat sind sowohl mindestens ein p-Kanal-MOS-Transistor und mindestens ein n-Kanal-MOS-Transistor realisiert. Die Erfindung macht sich die Erkenntnis zunutze, daß in p-Kanal-MOS-Transistoren bei entsprechender Ansteuerung sich ein vergrabener leitender Kanal (sogenannter buried channel) ausbildet, in n-Kanal-MOS-Transistoren dagegen sich ein leitender Kanal entlang der Oberfläche des Substrats, das heißt an der Grenzfläche zum Gatedielektrikum (sogenannter surface channel) ausbildet. In der CMOS-Schaltungsanordnung bildet sich somit im Bereich der p-Kanal-MOS-Transistoren der Kanal innerhalb der Si₁₋ₓGeₓ-Schicht aus, während sich im Bereich der n-Kanal-MOS-Transistoren der leitende Kanal im Bereich der zweiten Siliziumschicht ausbildet. Dadurch ist die Ladungsträgerbeweglichkeit im Bereich der p-Kanal-MOS-Transistoren durch die Si₁₋ₓGeₓ-Schicht und im Bereich der n-Kanal-MOS-Transistoren durch die zweite Siliziumschicht bestimmt.

Für den p-Kanal-MOS-Transistor wird die höhere Löcherbeweglichkeit in der Si₁₋ₓGeₓ-Schicht ausgenutzt. In der Si₁₋ₓGeₓ-Schicht entsteht in der z-Richtung, in der die Si₁₋ₓGeₓ-Schicht aufwächst, eine Zugspannung. Diese Zugspannung in z-Richtung hebt das Band der schweren Löcher energetisch an und verändert seine Dispersion am T-Punkt in der Ebene senkrecht zur Spannungsrichtung, das heißt in Transportrichtung der Ladungsträger, in der Art, daß die Bandkrümmung leicht-Lochähnlich wird und damit die Massen der Löcher vermindert werden. Auf diese Weise ist der Platzbedarf der p-Kanal-MOS-Transistoren und n-Kanal-MOS-Transistoren gleich und gleichzeitig gleiche Steilheit und gleicher Sättigungsstrom sichergestellt. Die p-Kanal-MOS-Transistoren und die n-Kanal-MOS-Transistoren können daher in einer Prozeßabfolge hergestellt werden. Die Si₁₋ₓGeₓ-Schicht verläuft unterhalb des Kanalgebietes des n-Kanal-MOS-Transistors und stört den n-Kanal-MOS-Transistor in seiner Funktion nicht.

Vorzugsweise liegt der Germaniumgehalt der Si₁₋ₓGeₓ-Schicht zwischen 25 Prozent und 50 Prozent, das heißt x = 0,25 bis 0,50. Die Schichtdicke der verspannten Si₁₋ₓGeₓ-Schicht beträgt vorzugsweise zwischen 5 nm und 10 nm. Die Schichtdicke der ersten Siliziumschicht, die in der Literatur oft als buffer-layer bezeichnet wird und die unterhalb der Si₁₋ₓGeₓ-Schicht angeordnet ist, beträgt vorzugsweise zwischen 30 nm und 70 nm. Die Schichtdicke der zweiten Siliziumschicht, die in der Literatur oft als Cap-Layer bezeichnet wird, beträgt vorzugsweise zwischen 5 nm und 12 nm.

Die erste Siliziumschicht, die verspannte Si₁₋ₓGeₓ-Schicht und die zweite Siliziumschicht werden durch epitaktisches Aufwachsen auf einer Hauptfläche eines Halbleitersubstrats, das mindestens im Bereich in der Hauptfläche Silizium aufweist, gebildet. Als Halbleitersubstrat ist sowohl eine monokristalline Siliziumscheibe als auch ein SOI-Substrat oder ein Substrat, das im Bereich der Hauptfläche SiC aufweist, geeignet.

Vorzugsweise werden an der Hauptfläche zunächst Isolationsstrukturen gebildet, die aktive Gebiete für den n-Kanal-MOS-Transistor und den p-Kanal-MOS-Transistor definieren. Nachfolgend werden die erste Siliziumschicht, die verspannte Si₁₋ₓGeₓ-Schicht und die zweite Siliziumschicht durch selektive Epitaxie aufgewachsen. Dadurch wird sichergestellt, daß die verspannte Si₁₋ₓGeₓ-Schicht in den aktiven Gebieten defektfrei aufwächst.

Im folgenden wird die Erfindung anhand eines Ausführungsbeispiels, das in den Figuren dargestellt ist, näher erläutert.
- Figur 1: zeigt ein Halbleitersubstrat mit Isolationsstrukturen, die ein aktives Gebiet für einen p-Kanal-MOS-Transistor und ein aktives Gebiet für einen n-Kanal-MOS-Transistor definieren, nach dem epitaktischen Aufwachsen einer ersten Siliziumschicht, einer verspannten Si₁₋ₓGeₓ-Schicht und einer zweiten Siliziumschicht.
- Figur 2: zeigt den Schnitt durch das Halbleitersubstrat nach Bildung von Gatedielektrikum, Gateelektroden und Source/Drain-Gebieten.

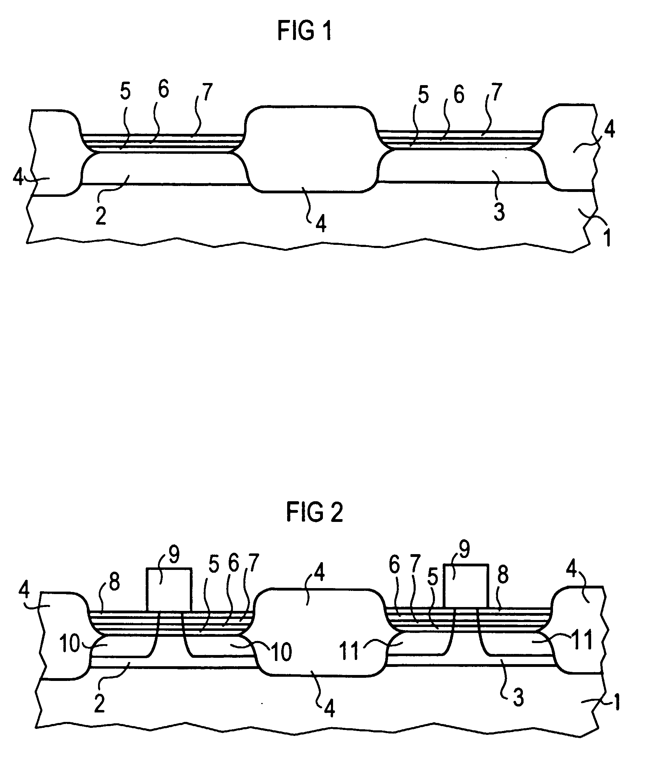

In einem Substrat 1 aus zum Beispiel p-dotiertem monokristallinem Silizium mit einer Grunddotierung entsprechend einem spezifischen Widerstand von 5 Ω cm wird durch maskierte Implantation von Arsen mit einer Energie von 180 keV und einer Dosis von 4 x 10¹³ cm⁻² eine n-dotierte Wanne 2 gebildet (siehe Figur 1).

Anschließend wird durch maskierte Implantation von Bor eine p-dotierte Wanne 3 gebildet. Die Implantation von Bor erfolgt bei einer Energie von 50 bis 70 keV mit einer Dosis von 1 bis 2 10¹³cm⁻².

Anschließend wird zum Beispiel in einem LOCOS-Prozeß eine Isolationsstruktur 4 gebildet, die im Bereich der n-dotierten Wanne 2 ein aktives Gebiet für einen p-Kanal-MOS-Transistor und im Bereich der p-dotierten Wanne 3 ein aktives Gebiet für einen n-Kanal-MOS-Transistor definiert. Die Isolationsstrukturen 4 können alternativ auch durch Auffüllen von Gräben mit isolierendem Material in einem Shallow Trench Isolationsprozeß gebildet werden. Die Isolationsstrukturen 4 reichen unterhalb der n-dotierten Wanne 2 und der p-dotierten Wanne 3 bis in das Substrat 1.

Anschließend wird durch selektive Epitaxie unter Verwendung eines SiH₂Cl₂ enthaltenden Prozeßgases eine erste Siliziumschicht 5 aufgewachsen. Die erste Siliziumschicht 5, die in der Literatur oft als Buffer-Schicht bezeichnet wird, wird in einer Schichtdicke von 30 bis 70 nm aufgewachsen. Zur Einstellung der Einsatzspannungen der später herzustellenden n-Kanal-MOS-Transistoren und p-Kanal-MOS-Transistoren wird die erste Siliziumschicht 5 p-dotiert. Dazu wird dem Prozeßgas Boran (B₂H₆) zugegeben, bis eine Schichtdicke von 15 bis 25 nm erreicht ist. Dann wird die erste Siliziumschicht 5 ohne Boran undotiert weitergewachsen um weitere 10 bis 50 nm. Die Prozeßtemperatur beim Aufwachsen der ersten Schicht 5 liegt zwischen 750 und 850°C.

Anschließend wird eine Si₁₋ₓGeₓ-Schicht 6 durch selektive Epitaxie unter Verwendung eines GeH₄ enthaltenden Prozeßgases bei einer Prozeßtemperatur zwischen 550 und 700°C aufgewachsen. Die Si₁₋ₓGeₓ-Schicht 6 wird in einer Schichtdicke von zum Beispiel 10 nm mit einem Germaniumgehalt x von 0,25 gebildet. Die Si₁₋ₓGeₓ-Schicht 6 kann alternativ in einer Schichtdicke von 5 nm bei einem Germaniumgehalt x von 0,5 gebildet werden.

Nachfolgend wird eine zweite Siliziumschicht 7, die in der Literatur oft als Cap-Layer bezeichnet wird, durch selektive Epitaxie unter Verwendung eines SiH₂Cl₂ enthaltenden Prozeßgases in einer Schichtdicke von 5 bis 12 nm undotiert aufgewachsen. Die Temperatur liegt dabei zwischen 550 und 700°C.

Nachfolgend wird durch eine thermische Oxidation bei 750°C und 120 Minuten ein Gatedielektrikum 8 aus SiO₂ gebildet. Das Gatedielektrikum 8 wird in einer Schichtdicke von zum Beispiel 4,5 nm gebildet (siehe Figur 2). Bei diese Oxidation wird von der zweiten Siliziumschicht 7 etwa 2 nm Si verbraucht. Die Verwendung der zweiten Siliziumschicht 7 ermöglicht daher die Bildung des Gatedielektrikums 8 durch Oxidation von Silizium. Auf diese Weise hergestelltes Siliziumoxid ist dem Oxid von SiGe wegen seiner besseren Haltbarkeit vorzuziehen.

Durch Abscheiden und Strukturieren einer n⁺-dotierten Polysiliziumschicht werden für den p-Kanal-MOS-Transistor und den n-Kanal-MOS-Transistor je eine Gateelektrode 9 gebildet. Nachfolgend werden durch maskierte Implantation mit Bor und/oder BF₂ mit einer Energie von 20 bis 30 keV und einer Dosis von 4 bis 8 10¹⁵cm⁻² p-dotierte Source/Drain-Gebiete 10 für den p-Kanal-MOS-Transistor gebildet. In einer weiteren maskierten Implantation mit Arsen bei einer Energie von 100 - 130 keV und einer Dosis von 4 - 8 10¹⁵cm⁻² werden n-dotierte Source/Drain-Gebiete 11 für den n-Kanal-MOS-Transistor gebildet.

Durch die Temperaturbelastungen im Prozeßablauf verläuft die Bor-Dotierung in der ersten Siliziumschicht 5 und trägt zur Dotierung im Oberflächenbereich bei. Auf diese Weise wird für den n-Kanal-MOS-Transistor eine ausreichend hohe Dotierung im Oberflächenbereich erzielt.

Zur Optimierung der Transistoreigenschaften können die p-dotierten Source/Drain-Gebiete 10 und die n-dotierten Source/Drain-Gebiete 11 jeweils in einer zweistufigen Implantation in bekannter Weise mit einem LDD-Profil und einem HDD-Profil versehen werden.

Die CMOS-Schaltungsanordnung wird durch Abscheidung einer Passivierungsschicht, Öffnen von Kontaktlöchern und Bildung einer Metallisierung in bekannter Weise fertiggestellt (nicht im einzelnen dargestellt).

Die n-dotierte Wanne 2 und die p-dotierte Wanne 3 werden mit einer maximalen Dotierstoffkonzentration von jeweils 1,5 x 10¹⁸ cm⁻³ gebildet. Durch diese hohe Dotierstoffkonzentration wird ein Punch through effect vermieden. Diese hohe Dotierstoffkonzentration ist in der Schaltungsanordnung zulässig, weil die Herstellung der n-dotierten Wanne und der p-dotierten Wanne 3 vor der Epitaxie erfolgte und somit die hohe Dotierung nicht bis an die Grenzfläche zum Gatedielektrikum 8 reicht.

In der beschriebenen CMOS-Schaltungsanordnung bildet sich bei Anliegen entsprechender Steuersignale in dem p-Kanal-MOS-Transistor, der in der n-dotierten Wanne 2 angeordnet ist, ein vergrabener leitender Kanal innerhalb der Si₁₋ₓGeₓ-Schicht 6 aus. In dem n-Kanal-MOS-Transistor, der in der p-dotierten Wanne 3 angeordnet ist, bildet sich bei entsprechender Ansteuerung ein leitender Kanal dagegen an der Oberfläche der zweiten Siliziumschicht 7 aus.

## Patentansprüche

1. Integrierte CMOS-Schaltungsanordnung,
- bei der ein Halbleitersubstrat (1) vorgesehen ist, das mindestens eine erste Siliziumschicht (5), eine verspannte Si₁₋ₓGeₓ-Schicht (6) und eine zweite Siliziumschicht (7) aufweist,
- bei der die verspannte Si₁₋ₓGeₓ-Schicht (6) im wesentlichen die gleiche Gitterkonstante wie die erste Siliziumschicht (5) und die zweite Siliziumschicht (7) aufweist,
- bei der in dem Halbleitersubstrat ein p-Kanal-MOS-Transistor und ein n-Kanal-MOS-Transistor realisiert sind.

2. Schaltungsanordnung nach Anspruch 1,
- bei der die erste Siliziumschicht (5) eine Dicke zwischen 30 nm und 70 nm aufweist,
- bei der die verspannte Si₁₋ₓGeₓ-Schicht (6) eine Dicke zwischen 5 nm und 10 nm und einen Germaniumgehalt zwischen 50 Atomprozent und 25 Atomprozent aufweist,
- bei der die zweite Siliziumschicht (7) eine Dicke zwischen 5 nm und 12 nm aufweist.

3. Verfahren zur Herstellung einer integrierten CMOS-Schaltungsanordnung,
- bei dem auf einer Hauptfläche eines Halbleitersubstrates (1), das mindestens im Bereich der Hauptfläche Silizium aufweist, epitaktisch eine erste Siliziumschicht (5), eine verspannte Si₁₋ₓGeₓ-Schicht (6) und eine zweite Siliziumschicht (7) aufgewachsen werden,
- bei dem in dem Halbleitersubstrat (1) ein p-Kanal-MOS-Transistor und ein n-Kanal-MOS-Transistor gebildet werden.

4. Verfahren nach Anspruch 3,
- bei dem Isolationsstrukturen gebildet werden, die ein aktives Gebiet für den n-Kanal-MOS-Transistor und ein aktives Gebiet für den p-Kanal-MOS-Transistor definieren,
- bei dem nach dem Aufwachsen der ersten Siliziumschicht (5), der verspannten Si₁₋ₓGeₓ-Schicht (6) und der zweiten Siliziumschicht (7) durch selektive Epitaxie für den n-Kanal-MOS-Transistor und für den p-Kanal-MOS-Transistor jeweils ein Gatedielektrikum (8), eine Gateelektrode (9) und Source/Drain-Gebiete (10, 11) gebildet werden.

5. Verfahren nach Anspruch 3 oder 4,
- bei dem die erste Siliziumschicht (5) mit einer Dicke zwischen 30 nm und 70 nm gebildet wird,
- bei dem die zweite Siliziumschicht (7) mit einer Dicke zwischen 5 nm und 10 nm gebildet wird,
- bei dem die Si₁₋ₓGeₓ-Schicht (6) mit einer Dicke zwischen 5 nm und 10 nm und einem Germaniumgehalt zwischen 50 Atomprozent und 25 Atomprozent gebildet wird.

6. Verfahren nach einem der Ansprüche 3 bis 5,
bei dem beim epitaktischen Aufwachsen der ersten Siliziumschicht (5) durch Zugabe von Dotierstoff die Einsatzspannung des n-Kanal-MOS-Transistors und/oder des p-Kanal-MOS-Transistors eingestellt wird.

7. Verfahren nach einem der Ansprüche 3 bis 6,
bei dem die Epitaxie unter Verwendung eines SiH₂Cl₂ und/oder GeH₄ enthaltenden Prozeßgases im Temperaturbereich zwischen 550°C und 850°C durchgeführt wird.
